# EUROPEAN PATENT APPLICATION

(11) **EP 2 544 239 A1**
(43) Date of publication of application: **09.01.2013**
(21) Application number: 11172969.5
(22) Date of filing: 07.07.2011
(51) Int. Cl.: H01L 27/24

(54) **Memory cell and method for manufacturing**

(71) Applicant: IMEC, 3001 Leuven (BE)
(72) Inventor: Wouters, Dirk, 3001 Leuven (BE)
(74) Representative: Hertoghe, Kris Angèle Louisa

(57) **Abstract**

A memory cell comprises a resistive switching element (142) connected in series with a junction-less field-effect-transistor (141). It is an advantage of a junction-less FET that it is easily scalable, hence allowing for smaller selectors to be used. Furthermore, the use of junction-less FETs as selectors provides advantages when using memory cells according to embodiments of the present invention in 3D stacked memory structures.

## Description

### Field of the invention

The present invention relates to memory cells, memory circuits made thereof, and methods for manufacturing such memory cells. More particularly the present invention relates to non-volatile memory cells comprising a reversible resistivity-switching layer used for storing data, to memory circuits comprising such memory cells and to methods for making such memory cells.

### Background of the invention

The evolution of the market of data storage memories indicates a growing need for ever-larger storage capacity ranging from gigabytes to hundreds of gigabytes or even to terabytes. This evolution is driven, amongst others, by new data consuming applications such as multimedia and gaming.

Current flash technology suffers from operation limitations (as low write speed and high operation voltages), as well as from scaling limitations (expected to stop flash scaling around the 45nm node for NOR gates and around the 22nm node for NAND gates). Therefore, a variety of new non-volatile memory concepts are investigated worldwide. Today, one of the most promising concepts is the resistive switching RAM, also often called resistive random-access memories (RRAM). Their physical switching mechanisms may not degrade with scaling. This type of memories comprises a resistor element that can be reversibly programmed in a high and a low conductive state. Various materials such as transition metal oxides, organic semiconductors or organometallic semiconductors can be used to manufacture such resistor element.

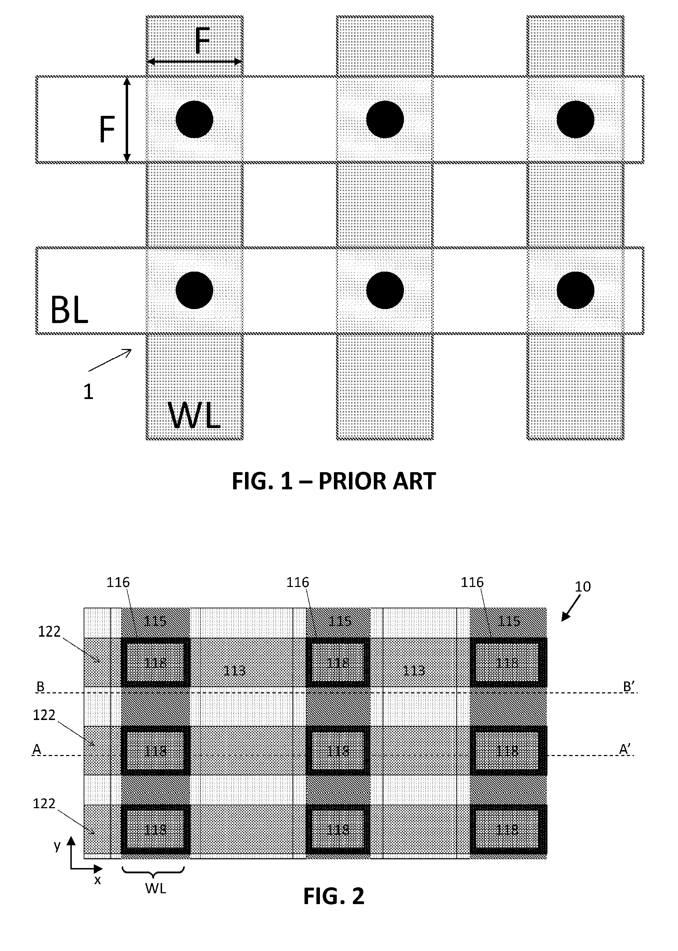

A resistive memory array, comprising a plurality of resistive memory cells, typically comprises a cross-bar array of top and bottom electrodes as illustrated in top view in FIG. 1. A resistive memory cell 1 comprises a plurality of first electrodes (e.g. word lines WL) and a plurality of second electrodes (e.g. bit lines BL) which, together with an active layer (not illustrated in FIG. 1) between the first and second electrodes, form a plurality of cross-point memory cells. The resistivity of the memory cell 1 can be changed by changing properties of the active layer in response to a voltage applied between the corresponding word line WL and the bit line BL. Theoretically, dimensions of the smallest RRAM memory cell are 4F² (where F refers to half the minimum pitch), and such memory cell has only two terminals (one is vertical (WL) and another is horizontal (BL)). The storage element or memory cell is thus built at the cross-point of an electrically conductive word line (WL) and a bit line (BL), often two metal wires, so it is called a cross-point structure (X-point structure). RRAM can support data access in this structure by properly controlling the voltages applied on WL's and BL's.

Moreover, the cross-point structure can grow in a third dimension and as such may form an intra-die stacking structure. The memory storage cell is located in between any two adjacent metal layers which are used as interconnects. Within a same die size, the multiple memory layers further improve the memory density as also presented by Lee et al. in "2-stack 1D-1R cross-point structure with oxide diodes as switch elements for high density resistance RAM applications", Electron Devices Meeting 2007, IEDM 2007, IEEE International, 10-12 December 2007, pp. 771-774. Hence, RRAM is expected to replace NAND flash memory as main storage in near future.

Resistive switching memories are being integrated using structures derived from the 1T/1C (one transistor/one capacitor) concept as used in dynamic RAM. The resistor element, comprising the resistive switching material, is stacked on top of a semiconductor device such as a MOS transistor, a bipolar transistor, or a diode and accessed through the bit-line. The resistor element is placed between metal lines or between the contact to the transistor and first metal level, typically within the back-end-of-line (BEOL) section of the integrated circuit.

### Summary of the invention

It is an objective of embodiments of the present invention to provide a new selector type for a resistive memory cell which has one or more of the desired advantages such as no or negligible sneak leakage, no or negligible leakage current (e.g. <0.5 pA @ 15 nm node), high drive current (e.g. >50 µA @ 15 nm node) and/or bipolar/unipolar capability. It is an advantage of a selector for a resistive memory cell according to embodiments of the present invention that it overcomes the disadvantages of existing selector types.

The above objective is accomplished by a method and device according to the present invention.

In a first aspect, the present invention provides a memory cell comprising a first resistive switching element connected in series with a selector, wherein the selector is a first junction-less field-effect-transistor (FET). The junction-less field-effect-transistor has, as the word indicates, no junctions. The junction-less FET can be implemented by a nanostructure, e.g. a nanowire, where source, drain and channel are uniformly doped, rather than the channel being delimited from source and drain, respectively, by means of abrupt junctions as is known in the art. As source, drain and channel are uniformly doped, source and drain cannot be distinguished from the channel, and therefore in the context of the present invention are not called as such, but are indicated as bottom regions and top regions of a region of transistor material. It is an advantage of a junction-less transistor that it is more easily scalable than other types of selectors, hence allowing for smaller selectors to be used. Furthermore, the use of junction-less FETs as selectors provides advantages when using memory cells according to embodiments of the present invention in 3D stacked memory structures.

It is an advantage of particular embodiments of the present invention that a selector is used in a resistive memory cell without increasing the cell size, or otherwise said, with preserving a small cell size, for example equal or close to 4F².

It is an advantage of particular embodiments of the present invention that scalability of a resistive memory cell is enhanced.

It is an advantage of particular embodiments of the present invention that more than one resistive memory cell may be stacked upon one another, thereby increasing the storage capacity or bit density of the memory circuit formed out of a plurality of memory cells according to embodiments of the present invention.

In embodiments of the present invention, the first junction-less field-effect-transistor may be a vertical transistor. A vertical transistor is a transistor laid out substantially perpendicular with respect to a substrate onto which the transistor is manufactured. A vertical transistor distinguishes from a planar transistor where a select electrode and a first and second main electrode, e.g. a gate, and a source and drain, respectively, are placed in the plane of the substrate. The use of a vertical transistor as a selector allows to increase the density of memory cells in an array, hence allowing the provision of smaller memories with higher capacity.

In embodiments of the present invention, the first junction-less field-effect transistor may comprise
- a stack of layers substantially lying in a plane, the stack at least comprising a conductive gate layer in between a first and a second dielectric layer;
- a region of transistor material through the stack of layers, the region of transistor material comprising a bottom region, a top region and a channel region having a sidewall part in between the bottom region and the top region, the region of transistor material comprising a poly-crystalline semiconducting material with a doping concentration and doping polarity, and wherein the region of transistor material is arranged along a direction substantially perpendicular to the plane of the stack of layers; and
- a gate dielectric layer along at least the channel region, at least in between the channel region and the conductive gate layer.

The bottom and top region have respectively a doping polarity being the same as the doping polarity of the channel region. The bottom and top region have respectively preferably a doping concentration being the same as the doping concentration of the channel region.

Such junction-less field-effect transistor according to embodiments of the present invention is easy to manufacture, in particular because no manufacturing of steep junctions is required. There are no junctions in between the bottom region and the channel region nor in between the channel region and the top region. The region of transistor material is larger than conductive gate layer so that part of the region of transistor material forms (junction-less) source and drain regions, called bottom and top regions in the context of the present invention, at either side of the channel region, the channel region being that part of the region of transistor material which is used as the channel, i.e. which is adjacent the conductive gate layer.

In embodiments of the present invention, the first junction-less field-effect transistor may be provided on a conductive layer, such as for example a metal layer or a doped semiconductive layer. This conductive layer may be used for conducting current when the selector is switched on. In particular embodiments, the first junction-less field-effect transistor may be made on a conductive layer in a substrate, which conductive layer can then typically be manufactured by means of standard semiconductor processing. In alternative embodiments, the first junction-less field-effect transistor may be made on a conductive, e.g. metal, layer provided on a substrate substantially parallel to the plane of the stack of layers and in contact with the bottom part of the region of transistor material. Such conductive, e.g. metal, layer can advantageously be used for 3D stacking of memory cells according to embodiments of the present invention. The conductive, e.g. metal, layer of the junction-less field-effect transistor may be patterned. In a memory cell according to alternative embodiments of the present invention, the first junction-less field-effect transistor may be made in or on a substrate.

In a memory cell according to embodiments of the present invention, the first resistive switching element may comprise a top electrode and a resistive switching material electrically connected to the top electrode. The first resistive switching element may furthermore comprise a bottom electrode, whereby the resistive switching element is electrically connected between the top electrode and the bottom electrode. In particular embodiments of the present invention, the bottom electrode may comprise metal deposited on top of the region of transistor material of the first junction-less field-effect transistor. The metal may be, but does not need to be, silicidated. Alternatively, the bottom electrode may comprise at least part of the top region of the region of transistor material of the first junction-less field-effect transistor. In such embodiments, the bottom electrode may comprise silicidated material of the at least part of the top region of transistor material of the first junction-less field-effect transistor.

In a second aspect, the present invention provides a memory circuit comprising a plurality of memory cells according to embodiments of the present invention.

Such memory circuit may comprise a first memory cell comprising a first resistive switching element connected in series with a first junction-less field-effect-transistor (FET) and a second memory cell comprising a second resistive switching element connected in series with a second junction-less field-effect-transistor (FET), wherein the second junction-less field-effect-transistor (FET) is in parallel with the first junction-less field-effect-transistor (FET) and wherein the first junction-less field-effect-transistor (FET) and the second junction-less field-effect-transistor (FET) share a conductive gate layer.

It is an advantage of certain embodiments that a selector is used in a resistive memory cell whereby a dual gate is used, i.e. one gate may drive 2 adjacent selectors, e.g. transistors. As such scalability is increased as small cell size is allowed.

A memory circuit according to embodiments of the present invention may comprise a vertical stack of at least a first and another memory cell according to memory cell embodiments of the first aspect of the present invention. The another memory cell may be physically top to bottom inverted with respect to the first memory cell. The first and the another memory cell may comprise the metal layer provided on a substrate substantially parallel to the plane of the stack of layers and in contact with the bottom part of the region of transistor material, wherein the metal layer of the first and the another memory cell is shared.

In a third aspect, the present invention provides a method of manufacturing a memory cell. The method comprises electrically connecting in series a resistive switching element and a junction-less field-effect-transistor.

It is an advantage of particular embodiments that the process temperature for manufacturing a memory cell may be limited.

A method according to embodiments of the present invention may comprise:
- providing a stack of layers on a substrate, the stack of layers substantially lying in a plane, the stack comprising a conductive gate layer sandwiched in between a first and a second dielectric layer;
- providing a region of transistor material through the stack of layers, the region of transistor material having a bottom region, a top region and a channel region having a sidewall part in between the bottom region and the top region, the region of transistor material comprising a poly-crystalline semiconducting material with a doping concentration and doping polarity, and wherein the channel region is arranged along a direction substantially perpendicular to the plane of the stack of layers;
- providing a gate dielectric layer along at least the channel region, at least in between the channel region and the conductive gate layer;
- providing a resistive switching material on and in electrical contact with the top part of the region of transistor material; and
- providing a top electrode layer on and in electrical contact with the resistive switching material.

The bottom and top region have respectively a doping polarity being the same as the doping polarity of the channel region. The bottom and top region have respectively preferably a doping concentration being the same as the doping concentration of the channel region.

It is an advantage of certain embodiments that a selector is used in a resistive memory cell which has no junctions and a uniform doping along the device. This means the integration flow is not difficult as no source/drain extension regions (i.e. implantations and additional temperature steps) have to be done.

A method according to embodiments of the present invention may further comprise providing an electrically conductive bottom electrode in between the top region and the resistive switching material, on and in electrical contact with the top region.

A method according to embodiments of the present invention may furthermore comprise providing a metal layer on the substrate, e.g. on the semiconducting substrate. Before providing the stack of layers, this metal layer may be patterned.

A method according to embodiments of the present invention may furthermore comprise, before providing a resistive switching material, providing a bottom electrode on and in electrical contact with the top part of the region of transistor material.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the figures

The invention will now be described further, by way of example, with reference to the accompanying drawings, in which:
FIG. 1 illustrates a prior art array of memory cells.
FIG. 2 is a top view of an array of memory cells according to embodiments of the present invention.
FIG. 3 is a side view section of a substrate onto which a conductive layer, e.g. metal layer, has been applied; FIG. 3A shows a section where the conductive layer, e.g. metal layer, is unpatterned, and FIG. 3B shows a section where the conductive layer, e.g. metal layer, has been patterned.
FIG. 4 is a top view after patterned conductive material, e.g. metal, deposition (corresponding to the side view of FIG. 3B).
FIG. 5 is a schematic view of an array of memory cells according to embodiments of the present invention, where the conductive layer, e.g. metal layer, is patterned (as in FIG. 3B) so as to serve as electrode elements each common to a plurality but not all the memory cells (in the example illustrated common to rows of memory cells).
FIG. 6 is a schematic view of an array of memory cells according to embodiments of the present invention, where the conductive layer, e.g. metal layer, is unpatterned (as in FIG. 3A) so as to serve as an electrode element common to all the memory cells.
FIG. 7 shows an A-A' and B-B' side view section after application of a stack of dielectric and electrically conductive layers on the conductive layer, e.g. metal layer.
FIG. 8 is a top view of the structure after application of a stack of dielectric and electrically conductive layers on the conductive layer, e.g. metal layer.
FIG. 9 shows an A-A' and B-B' side view section of the structure of FIG. 7 and FIG. 8, after provision of a trench in the stack of layers.
FIG. 10 shows a top view of the structure of FIG. 9.
FIG. 11 shows an A-A' and B-B' side view section of the structure of FIG. 9 and FIG. 10 after filling the trench with dielectric material.
FIG. 12 shows an A-A' and B-B' side view section of the structure of FIG. 11 after removing dielectric material outside the trenches.
FIG. 13 shows a top view of the structure of FIG. 12.
FIG. 14 shows a top view of a structure of FIG. 13 after removal of parts of the dielectric material.
FIG. 15 shows an A-A' side view section of the structure of FIG. 14.
FIG. 16 shows a B-B' side view section of the structure of FIG. 14 and FIG. 15 after gate dielectric deposition.
FIG. 17 shows an A-A' side view section of the structure of FIG. 14 and FIG. 15 after gate dielectric deposition.
FIG. 18 shows an A-A' side view section of the structure of FIG. 16 and FIG. 17 after the gate dielectric has been removed outside the trenches.
FIG. 19 shows a top view of the structure illustrated in FIG. 18.
FIG. 20 shows an A-A' side view section of the structure of FIG. 18 and FIG. 19 after the trenches have been filled with transistor material.
FIG. 21 shows a top view of the structure of FIG. 20.
FIG. 22 shows an A-A' side view section of the structure of FIG. 20 and FIG. 21 after provision of a resistive memory layer and a top electrode.
FIG. 23 illustrates the working principle of a double gate pinch-off TFET.
FIG. 24 illustrates a memory circuit array according to particular embodiments of the present invention.

Any reference signs in the claims shall not be construed as limiting the scope.

In the different drawings, the same reference signs refer to the same or analogous elements.

### Detailed description of the invention

The present invention will be described with respect to particular embodiments and with reference to certain drawings but the invention is not limited to those embodiments. The drawings described are only schematic and are non-limiting. In the drawings, the size of some of the elements may be exaggerated and not drawn on scale for illustrative purposes. The dimensions and the relative dimensions do not necessarily correspond to actual reductions to practice.

Moreover, the terms over, under, underneath and the like in the description and the claims are used for descriptive purposes and not necessarily for describing relative positions. It is to be understood that the terms so used are interchangeable under appropriate circumstances and that the embodiments described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

Reference throughout this specification to "one embodiment" or "an embodiment" means that a particular feature, structure or characteristic described in connection with the embodiment is included in at least one embodiment. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments, various features sometimes grouped together in a single embodiment, figure, or description thereof for the purpose of streamlining the disclosure and aiding in the understanding of one or more of the various features. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as encompassing one or more separate embodiments of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to RRAM, reference to Resistive Random-Access Memory is meant to be made. RRAM is a non-volatile memory type, in which the basic idea is that a dielectric, which is normally insulating, can be made to conduct through a filament or conduction path formed after application of a sufficiently high voltage over the dielectric. Once the filament has been formed, it may be reset (broken, resulting in a first, higher resistance state of the memory element) or set (re-formed, resulting in a second, lower resistance state of the memory element) by appropriately applied voltages.

Where in embodiments of the present invention reference is made to a PO FET, reference is meant to be made to a pinch-off field-effect transistor. Such FETs are also called junction-less transistors, for example junction-less nanowire transistors (JNT). In the context of the present invention, the terms a junction-less FET and a pinch-off FET are used interchangeably. The physical mechanism of a planar version of a junction-less transistor is described broadly in WO 2010/025938.

In one aspect, the present invention relates to a memory cell comprising a first resistive switching element electrically connected in series with a junction-less or pinch-off field-effect-transistor (FET).

In another aspect, the present invention relates to a memory circuit comprising a plurality of memory cells according to an aspect of the present invention.

In yet another aspect, the present invention also relates to a method for manufacturing a memory cell comprising a resistive switching element connected in series with a junction-less or pinch-off field-effect-transistor (FET).

With reference now to the drawings, different process steps for a method for manufacturing a memory cell comprising a resistive switching element electrically connected in series with a junction-less or pinch-off field-effect-transistor (FET) according to certain embodiments of the present invention, or an array of such memory cells, are described in more detail.

Three different views will be explained in the following paragraphs. FIG. 2 shows a schematic representation of the top view of an array 10 of memory cells according to embodiments of the present invention. In FIG. 2, sections A-A' and B-B' are noted to which there will be referred in explaining the different process steps in more detail. Section A-A' is a section through a row of resistive memory cells arranged in the array 10, and section B-B' is a section in between two rows of resistive memory cells in the array. Throughout the following description, more specifically reference will be made to the top view process flow, to a side view process flow for section A-A' and to a side view process flow for section B-B'.

### PROVISION OF A CONDUCTIVE LAYER, E.G. METAL LAYER

A substrate 100 is provided. In embodiments of the present invention, the "substrate" may include a semiconductor substrate such as e.g. a silicon, a gallium arsenide (GaAs), a gallium arsenide phosphide (GaAsP), an indium phosphide (InP), a germanium (Ge), or a silicon germanium (SiGe) substrate. The "substrate" may include, for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements or layers that underlie a layer or portions of interest. Also, the "substrate" may be any other base on which a layer is formed, for example a glass or metal layer. Accordingly a substrate may be a wafer such as a blanket wafer or may be a layer applied to another base material, e.g. an epitaxial layer grown onto a lower layer. The term "crystalline substrate" includes various forms of crystalline material such as monocrystalline or microcrystalline.

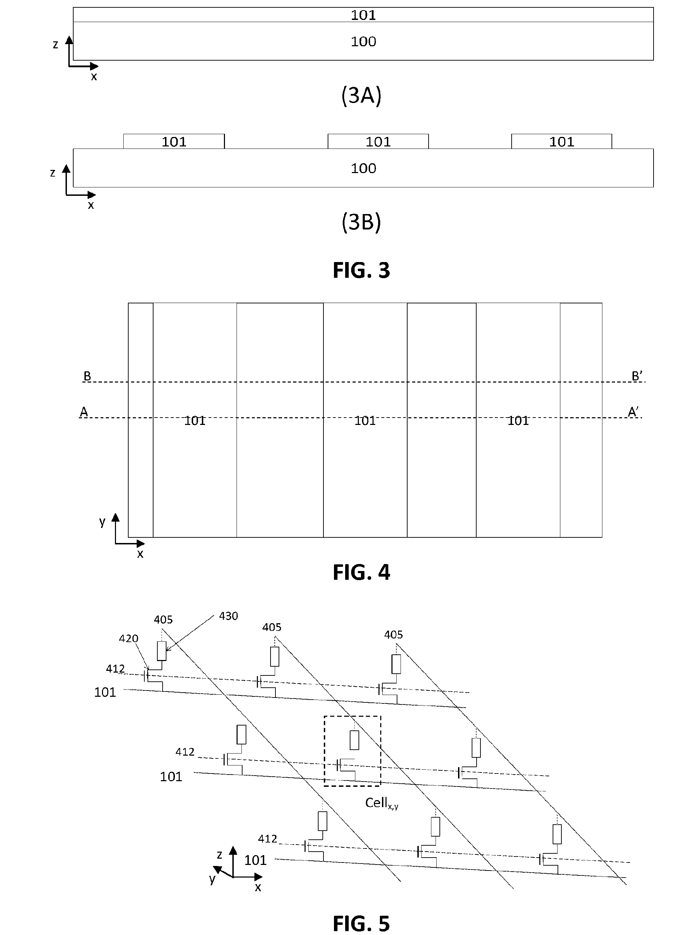

In particular embodiments of the present invention, a conductive layer, e.g. a doped semiconductor layer or a metal layer 101 is provided on the substrate 100. In the following, reference is made to a metal layer 101, the present invention, however, not being limited thereto, and any suitable electrically conductive layer being intended. The metal layer 101 may comprise any suitable metal material for conducting electrical signals, for example Al, Cu, TiN or W. The metal layer 101 may be formed on the substrate 100 using deposition techniques known for a person skilled in the art. In embodiments of the present invention, the metal layer 101 may for example be applied as a blanket film, e.g. over the whole surface of the substrate 100, and left as such. The metal layer 101 is then unpatterned. This is illustrated in FIG. 3A for a side view section A-A' or B-B'. Alternatively, the metal layer 101 may be patterned. Hereto, again a blanket layer of metal may be applied over the substrate 100, and superfluous metal material (which is present at locations where it should not be present) may be removed. Alternatively, other methods for applying a patterned metal layer as known to a person skilled in the art may be used. The result is illustrated in FIG. 3B for a side view section A-A' or B-B', and in FIG. 4 for a top view. The substrate 100 lies in a plane, e.g. an xy-plane, and the metal layer 101 is formed in a first direction, e.g. the y-direction, which is parallel to the substrate plane.

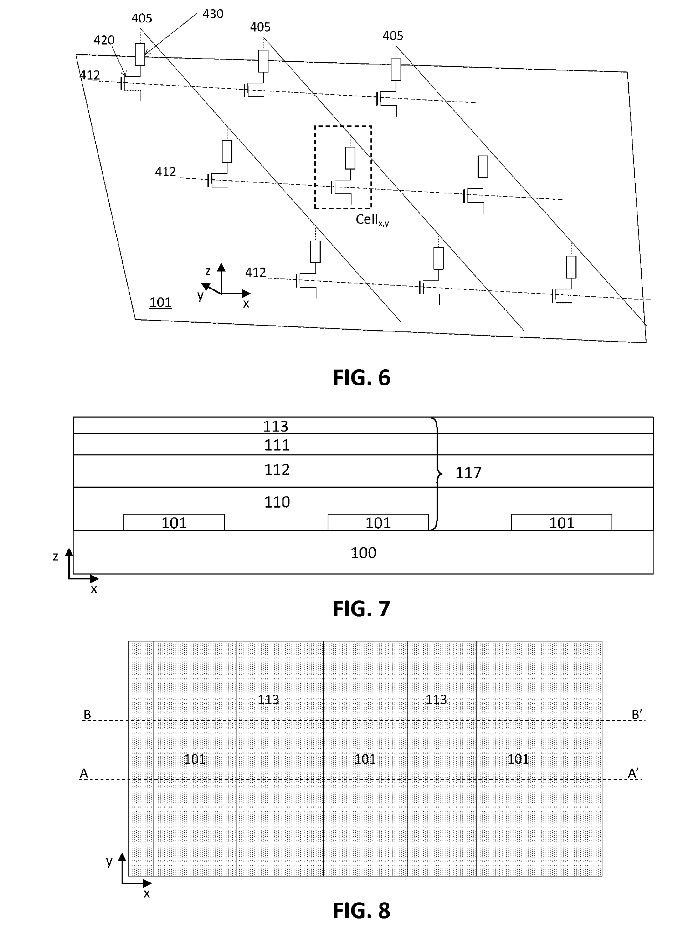

The metal layer 101 will serve as a first electrode element, which may be common to a plurality of (if the metal layer is patterned as in FIG. 3B) or even all (if the metal layer is unpatterned as in FIG. 3A) the memory cells which will be formed. In a prior-art array of memory cells, as for example illustrated in FIG. 1, the bottom metal layer BL serves as the so-called cross-point wordline (XP-WL) of the memory cell and has to be patterned for each memory cell or row of memory cells. A selector (not illustrated in FIG. 1) is connected on top of the WL. In series with the selector, a memory element is formed. The memory element is connected with a cross-point bitline BL (XP-BL). As will be illustrated further, according to embodiments of the present invention it is the gate 412 of the selector 420, i.e. of the pinch-off FET transistor, which will serve as the cross-point wordline (XP-WL) of the memory cell, rather than the bottom electrode of the selector 420 formed by the metal layer 101. Hence, in accordance with embodiments of the present invention, the metal layer 101 has no strict sense anymore in terms of wordline or bitline and may therefore either be patterned as in FIG. 5, illustrating conductive lines 101, or may be an unpatterned plane 101 as shown schematically in FIG. 6.

It is an advantage that the bottom metal layer 101 may be formed as a plane over the whole substrate surface. It is an advantage that no patterning of the metal layer 101 is needed and as such, for at least some embodiments of the present invention, process steps may be reduced.

For the further detailed description of embodiments of present invention, reference will be made to the example of a patterned metal layer 101 as illustrated in FIG. 3B and FIG. 4. Nevertheless, this is not intended to be limiting for the present invention; in alternative embodiments one may adapt the following by using an unpatterned metal layer 101.

The metal layer 101 as indicated above is only necessary in case of 3D stacking of memory cells. In alternative embodiments of the present invention, any conductive layer e.g. present in the substrate, can function as bottom electrode of the selector.

### STACK OF LAYERS FORMATION

In a next step, a stack of layers 117 is formed on top of the substrate comprising a conductive layer, on top of the metal layer 101 and/or on top of the substrate 100. In the embodiments illustrated, the stack of layers 117 is formed on top of and in physical contact with the metal layer 101 and on top of and in physical contact with the substrate 100 where no metal layer 101 is present. The stack of layers 117 lies in a plane substantially parallel with the plane of the substrate 100, e.g. an xy-plane.

The stack of layers 117 comprises a conductive gate layer 112 in between a first 110 and a second dielectric layer 111 (FIG. 7 for side view section A-A' and B-B'; FIG. 8 for top view). First the first dielectric layer 110 is thus formed on the metal layer 101 and/or the substrate 100. Thereafter the conductive gate layer 112 is formed on the first dielectric layer 110 and thereafter the second dielectric layer 111 is formed on the conductive gate layer 112. The stack of layers 117 is provided in a plane substantially parallel to the plane of the substrate 100, e.g. an xy-plane, which may more particularly for example be a horizontal plane.

Depending on whether metal layer 101 is patterned or unpatterned, the first dielectric layer 110 is in contact with both the metal layer 101 and the substrate 100 (in case of a patterned metal layer 101, as illustrated in FIG. 7) or with the metal layer 101 alone (in case of an unpatterned metal layer 101, not illustrated).

The stack of layers 117 may further comprise a stop layer 113 which is formed on top of the second dielectric layer 111.

The stack of layers 117 with or without the stop layer 113 may be formed using deposition techniques known for a person skilled in the art such as for example chemical vapor phase deposition (CVD), e.g. low pressure CVD (LPCVD).

The gate layer 112 preferably comprises a conductive material such as a metal, for example Cu, Al, TiN, W, or conductive semiconductor material such as e.g. polysilicon (poly-Si) or polysilicongermanium (Poly-SiGe). The gate layer 112, if comprising conductive semiconductor material, may additionally be doped in order to be highly conductive.

The first dielectric layer 110 and second dielectric layer 111 may be of same or different materials. The first and/or second dielectric layers 110, 111 may for example comprise or consist of a semiconductor oxide, a semiconductor nitride, or a low K dielectric material. Suitable dielectric materials are for example silicon oxide or silicon nitride.

The stop layer 113 acts as a stop layer during possible following processing steps, for example during etching or CMP. Its material may thus be dependent on the material or properties of the layer present on top of the stop layer 113, and possibly of etch chemistries used. The stop layer 113 may for example comprise or consist of polysilicon, oxides e.g. SiO, nitrides e.g. SiN, oxynitrides e.g. SiON, aluminum oxide e.g. Al₂O₃, carbides.

As will be indicated below, the gate layer 112 acts as the wordline of the memory cell according to embodiments of the present invention.

### TRENCH FORMATION IN THE STACK OF LAYERS

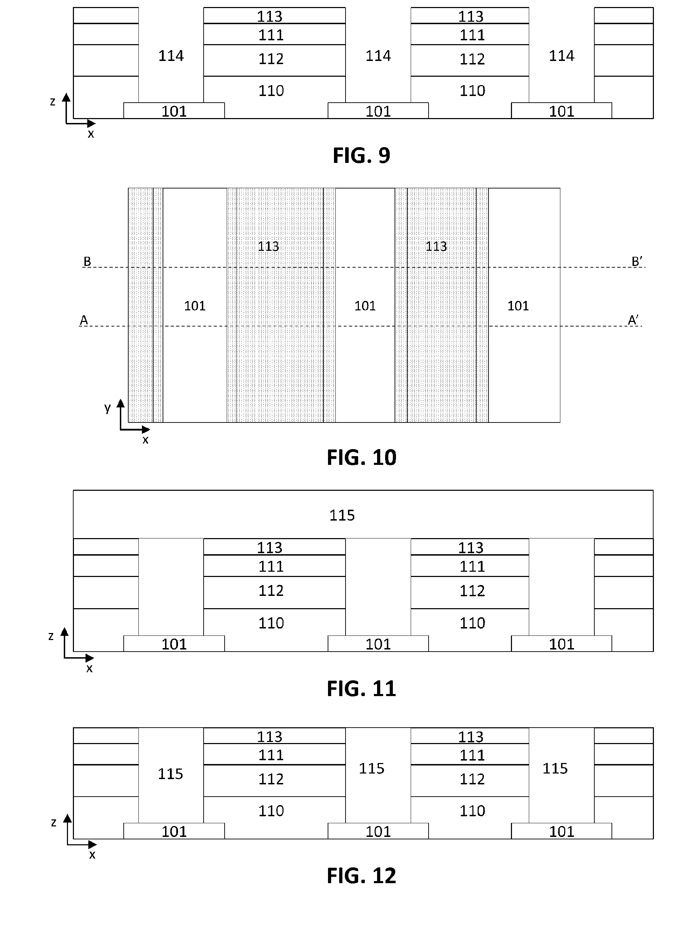

In a next step at least one trench 114 is formed in the stack of layers 117, thereby exposing part of the metal layer 101 (FIG. 9 for side view sections A-A' and B-B'; FIG. 10 for top view) or conductive layer in the substrate 100 (not illustrated). The formation of the at least one trench 114 may be done using standard process techniques well known for a person skilled in the art such as for example a lithography step comprising forming a hard mask layer on the stack of layers 117 and a photoresist layer on the hard mask layer, exposing and etching the photoresist layer, patterning the hard mask layer by using the etched photoresist layer, and after removing the photoresist layer forming the trench 114 in the stack of layers 117 by etching through the stack of layers 117 using the hard mask layer. After forming the trench 114, the hard mask layer may be removed.

The trench 114 may have a depth direction which is substantially perpendicular to the plane of the substrate, e.g. the at least one trench 114 may be provided in the z-direction.

By providing the at least one trench 114 through the stack of layers 117, part of the stack of layers 117 is removed, more specifically part of the alternating conductive and dielectric layers 110, 112, 111 is removed.

After the at least one trench 114 formation, part of the metal layer 101 or the conductive layer in the substrate is thus exposed, more particularly at the bottom of the at least one trench 114.

The at least one trench 114, once filled in one of the further manufacturing steps, will comprise a channel region of the pinch-off field-effect-transistor which will be formed on the metal layer 101 or conductive layer in the substrate.

### TRENCH FILLING (channel isolation)

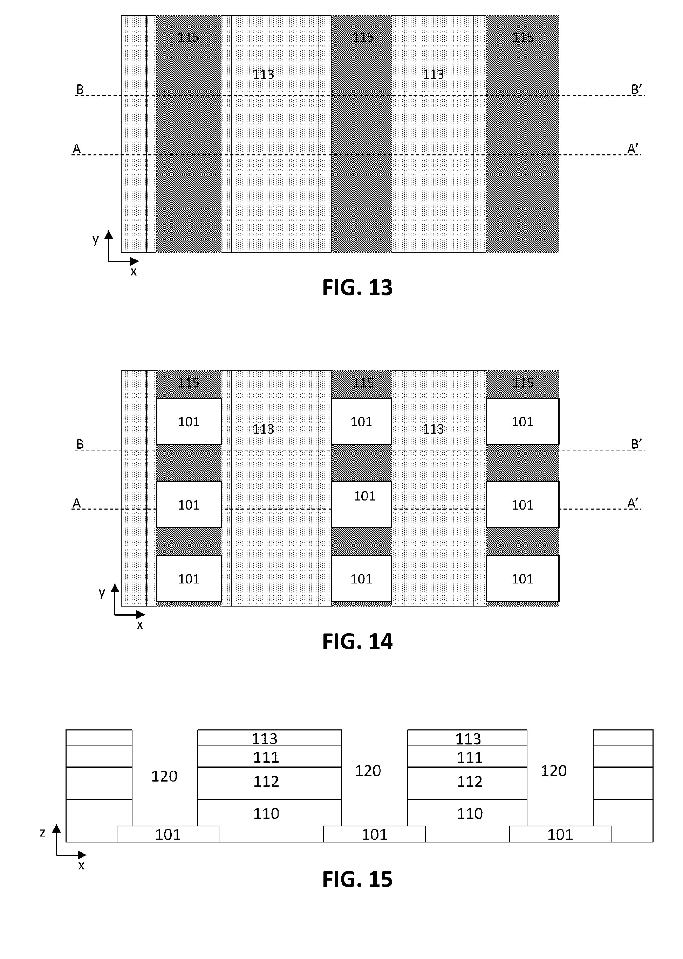

After forming at least one trench 114, the trench(es) are filled with a dielectric material 115 such as for example an oxide. Providing the dielectric material 115 in the trenches 114 may be done by depositing the dielectric material on the structure and in the trenches using techniques know by a person skilled in the art, as illustrated in FIG. 11 for side view sections A-A' and B-B'. Thereafter, part of the dielectric material which is present on top of the structure may be removed by any suitable planarising method, for example by an etching step, such as for example chemical-mechanical polishing (CMP). FIG. 12 illustrates a side view section A-A' or B-B'; and FIG. 13 illustrates the corresponding top view. In this planarising step, e.g. etching step, the stop layer 113 will prevent removal of underlying layers, e.g. etching through the underlying layers of the stack of layers 117.

### CHANNEL ETCH

In a next step parts of the dielectric material 115 are removed, as such again partially exposing the underlying metal layer 101 or conductive layer in the substrate. In top view (FIG. 14) holes are formed in the dielectric material 115, in a direction substantially perpendicular to the plane of the substrate, e.g. in a z-direction. In the embodiment illustrated in FIG. 14, the holes formed are square-like in a cross-section parallel to the plane of the substrate 100. The present invention is, however, not limited thereto; the holes may have any suitable shape in cross-section, such as for example circular or oval. The holes may have a regular or irregular shape in cross-section. In particular embodiments of the present invention, dimensions of the holes may be as small as about 10 by 10 nm.

The removal of part of the dielectric material 115 may be done by etching part of the dielectric material 115. In side view B-B', i.e. in between two rows of memory cells to be formed, the dielectric material 115 remains present in the previously formed trenches 114; hence after the step of channel etching for removing parts of the dielectric material 115, cross-section B-B' has not changed and still looks like FIG. 12. In side view A-A', i.e. in a cross-section through the memory cells to be formed, trenches 120 are formed in the dielectric material 115, as illustrated in FIG. 15, thereby again exposing the underlying metal layer 101 or the conductive layer in the substrate 100.

### GATE DIELECTRIC DEPOSITION

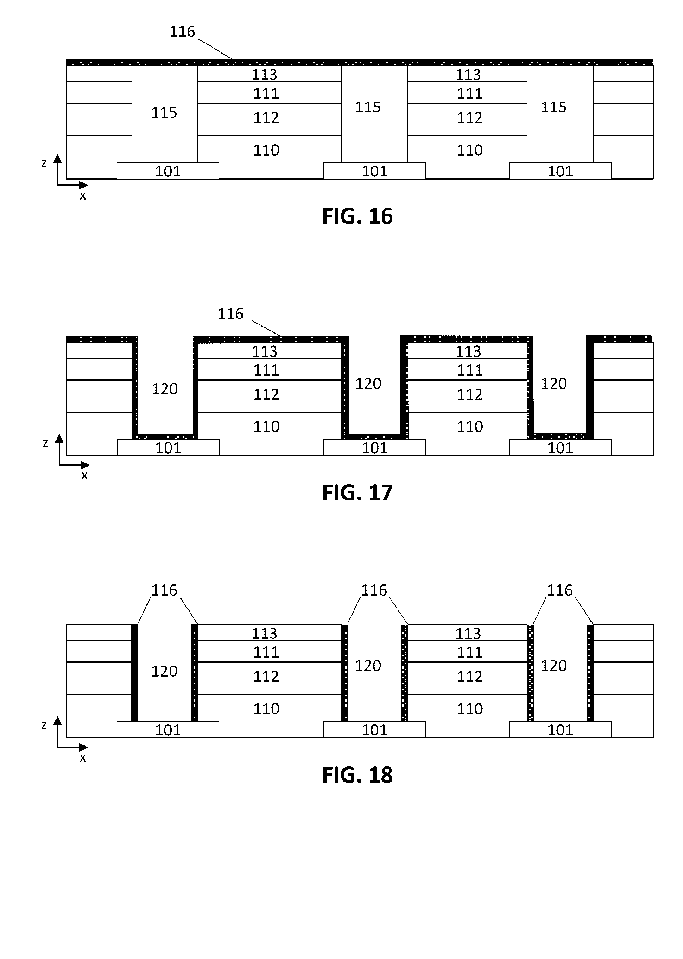

After re-exposing part of the underlying metal layer 101 in the above step of channel etching, a gate dielectric layer 116 is provided over the structure (i.e. on top of the stack of layers 117 with trenches filled with dielectric material 115 (side view B-B' illustrated in FIG. 16) and in the unfilled trenches 120 (side view A-A' illustrated in FIG. 17)). The gate dielectric layer 116 may be formed by deposition techniques such as for example CVD, e.g. MOCVD, or ALD. As such the gate dielectric layer 116 is provided conformally along the surfaces onto which the gate dielectric layer 116 is deposited, e.g. along the surfaces of the trenches 120.

Suitable materials for the deposited gate dielectric material are for example oxides or nitrides, such as e.g. silicon oxide or silicon nitride, or high K dielectrics.

### GATE DIELECTRIC ETCHING

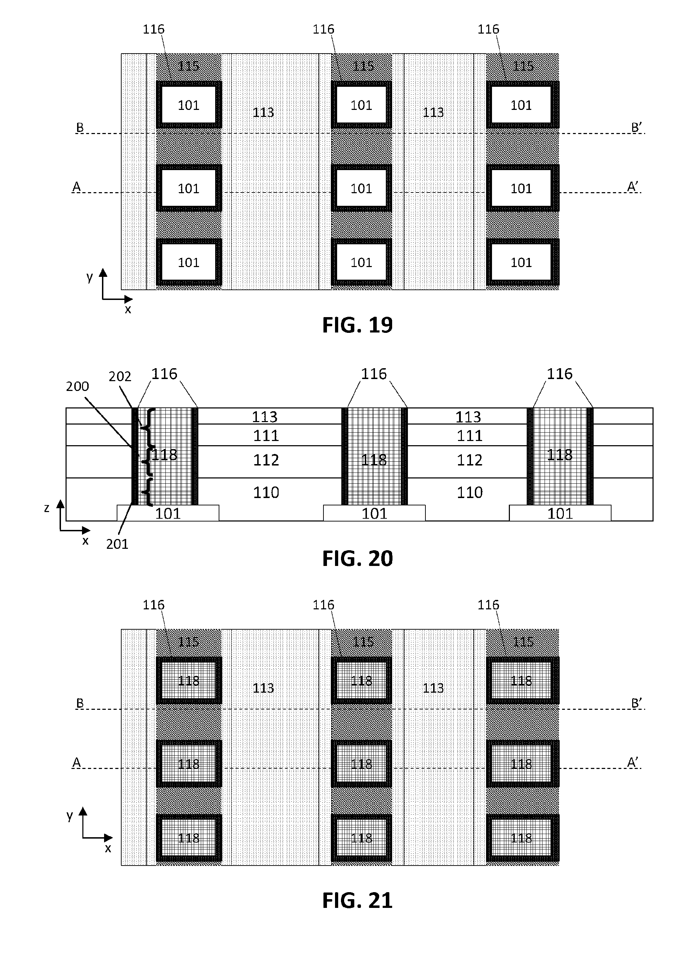

In a next step, part of the gate dielectric layer 116 is removed such that the gate dielectric layer 116 remains only present along the sidewalls of the trenches 120. In side view section B-B', the structure then again looks like FIG. 12. In side view section A-A' it is illustrated in FIG. 18 and in top view it is illustrated in FIG. 19.

In this step, all gate dielectric 116 different from the gate dielectric along sidewalls of the trenches 120 may be removed. In particular, part of the gate dielectric layer 116 at the bottom of the trenches 120 (and thus in contact with the underlying metal layer 101 or the conductive layer in the substrate) may be removed, in order to allow electrical contact between that metal or conductive layer and transistor material to be provided in a further step. Furthermore, part of the gate dielectric layer 116 on top of the stop layer 113 may be removed. Removal of the gate dielectric 116 from locations where it is not desired to keep it may be done by etching techniques as known for a person skilled in the art.

### TRANSISTOR MATERIAL DEPOSITION

In a next step the remaining trenches 120 are filled with a transistor material 118 (FIG. 20 for side view section A-A'; FIG. 21 for top view). The transistor material 118 may for example be Silicon or Germanium. This may be done for example by epitaxial growing of Silicon or Germanium on the exposed metal layer 101. As such poly-Si or poly-Ge may be formed in the trenches 120 which will serve at least partially as the channel for the pinch-off FET. The transistor material may be monocrystalline or polycrystalline. The transistor material 118 may be doped, for example by means of p-type or n-type dopant elements, so as to form a doped channel. Doping levels may be in the order of 10¹⁹ to 1021/cm³, for example about 5.10¹⁹/cm³. The doping of the transistor material 118 may be uniform throughout the trenches 120. By increasing the doping concentration of the channel, more current may flow through the device. It is an advantage of using germanium as transistor material as a low temperature process step may be used for the deposition of the germanium material 118 on the metal layer 101. For example Germanium may be grown directly on a TiN layer at 300 degrees Celsius using digermane (Ge₂H₆).

The transistor material 118 forms a channel region 200 having a sidewall adjacent the gate dielectric 116, a bottom region 201 adjacent the metal layer 101 or the conductive layer in the substrate 100, and a top region 202 opposite the bottom region 201, and which will be in contact with the resistive switching memory element. In particular embodiments the top region, bottom region and channel region comprise the same material with the same doping polarity and doping concentration.

The transistor material 118, the gate dielectric layer 116 and the conductive gate layer 112 form a vertical transistor; vertical being defined as substantially perpendicular or perpendicular to the plane of the substrate 100, which is considered a horizontal plane.

### RESISTIVE SWITCHING MEMORY ELEMENT DEPOSITION

In a next step, a resistive switching memory element is provided on top of the structure, more particularly at least on top of the top region 202 of the vertical FET.

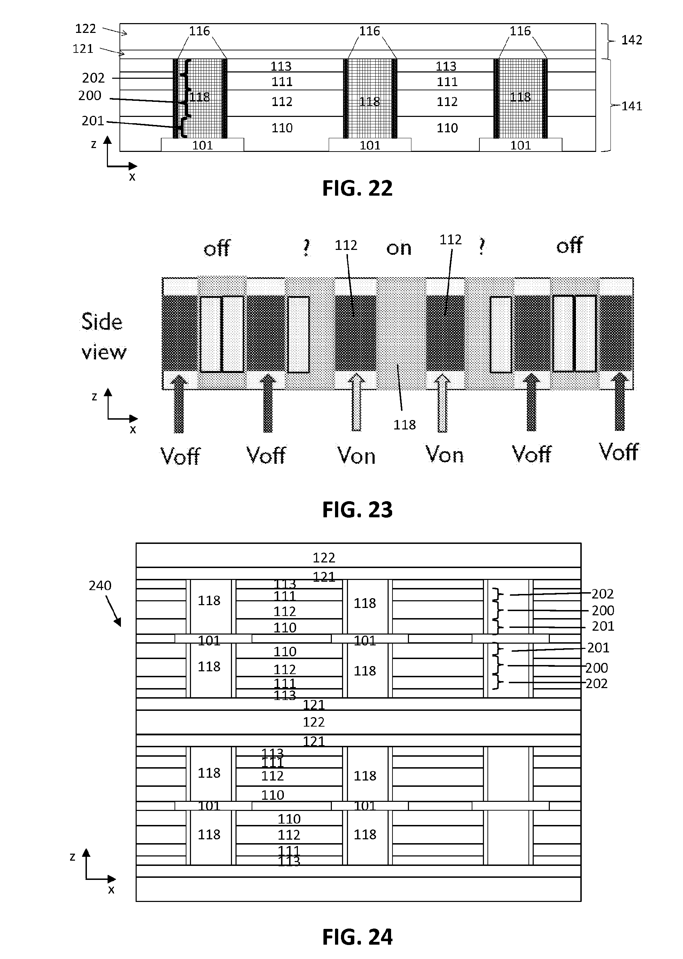

Hereto, a layer of resistive switching material 121 may be provided over the structure, at least over the locations where transistor material 118 has been deposited. A side view at an A-A' section is illustrated in FIG. 22. Suitable materials for the resistive switching memory layer 121may be phase change chalcogenides such as e.g. Ge₂Sb₂Te₅ or AglnsbTe, binary transition metal oxides such as e.g. NiO or TiO₂, HfO₂, perovskite materials such as e.g. Sr(Zr)TiO₃ or PCMO, solid-state electrolytes such as GeS, GeSe or Cu₂S, organic charge transfer complexes such as e.g. CuTCNQ, or organic donor-acceptor systems such as e.g. AIAIDCN.

The layer of resistive switching material 121 may be patterned so as to cover only one device, or so as to cover a plurality of memory cells in an array, the plurality of memory cells for example lying on a same row of the array. Alternatively, the patterning may be done only after deposition of the top electrode. Yet alternatively, the layer of resistive switching material 121 may not be patterned at all.

The resistive switching material layer 121, e.g. metal-oxide layer, serves as the resistive switching element.

### TOP ELECTRODE DEPOSITION

In a next step, a top electrode is provided on top of the structure. Hereto, on the resistive switching memory layer 121 a top electrode layer 122 is formed. This is ultimately only done over a single memory cell, or covering a plurality of memory cells in the array, the plurality of memory cells for example lying on a same row of the array. A side view A-A' illustration is shown in FIG. 22. At least the top electrode layer 122 and optionally also the resistive switching memory layer 121 are structured in a bit line.

The top electrode layer 122 may comprise any suitable electrically conductive material, such as metal material for conducting electrical signals, for example Al, Cu, TiN or W.

### BOTTOM ELECTRODE DEPOSITION

In particular embodiments of the present invention, before providing the resistive switching memory layer 121, a bottom electrode (not illustrated) may be provided, so that in the end the resistive switching memory layer 121 is connected between and electrically contacted to a bottom electrode and a top electrode 122.

In particular embodiments of the present invention, such bottom electrode may be formed by the highly doped top region 202 of the transistor material 118.

In alternative embodiments, a separate metal electrode may be provided. Often this is done by providing a metal layer over the complete structure, and etching away the metal where no bottom electrode should be present. The bottom electrode layer may comprise any suitable electrically conductive material, such as metal material for conducting electrical signals, for example Al, Cu, TiN or W. It is a disadvantage of this embodiment that a supplementary etch step is required.

In yet alternative embodiments, the bottom electrode may be formed by the top region 202 of the transistor material 118 which is silicidated.

In accordance with embodiments of the present invention, a memory circuit array is provided comprising a plurality of memory cells according to embodiments of the present invention. In the array, the plurality of memory cells may be logically organised in rows and columns. Throughout this description, the terms "horizontal" and "vertical" (related to the terms "row" and "column", respectively) are used to provide a co-ordinate system and for ease of explanation only. They do not need to, but may, refer to an actual physical direction of the device. Furthermore, the terms "column" and "row" are used to describe sets of array elements which are linked together. The linking can be in the form of a Cartesian array of rows and columns; however, the present invention is not limited thereto. As will be understood by those skilled in the art, columns and rows can be easily interchanged and it is intended in this disclosure that these terms be interchangeable. Also, non-Cartesian arrays may be constructed and are included within the scope of the invention. Accordingly the terms "row" and "column" should be interpreted widely. To facilitate in this wide interpretation, the present invention may refer to logically organised rows and columns. By this is meant that sets of memory elements are linked together in a topologically linear intersecting manner; however, that the physical or topographical arrangement need not be so. For example, the rows may be circles and the columns radii of these circles and the circles and radii are described in this invention as "logically organized" rows and columns. Also, specific names of the various lines, e.g. wordline and bitline, are intended to be generic names used to facilitate the explanation and to refer to a particular function and this specific choice of words is not intended to in any way limit the invention. It should be understood that all these terms are used only to facilitate a better understanding of the specific structure being described, and are in no way intended to limit the invention.

A final device according to embodiments of the present invention is illustrated in top view in FIG. 2. FIG. 2 shows an array of memory cells according to embodiments of the present invention, logically organized in rows and columns. The A-A' cross-section of the final device looks like FIG. 22, while the B-B' cross-section of the final device looks like FIG. 12.

The bottom part 141 of the device shown in FIG. 22 forms the pinch-off FET device which acts as a selector of the resistive memory cell. The top part 142 acts as the resistor element of the resistive memory cell and an electrode element. The top region 202 of the pinch-off FET serves as the bottom electrode of the resistor element of the resistive memory cell.

In alternative embodiments, not illustrated in the drawings, after forming the channel 118 of the pinch-off FET, one may also provide a separate metal layer (before forming the resistive switching layer121) which may act as the bottom electrode material for the resistor element of the resistive memory cell.

As can be appreciated in particular from FIG. 22 and FIG. 23, a common gate electrode layer 112 may be used by adjacent FET devices. Hence, in accordance with embodiments of the present invention, a pinch-off FET device shares a gate 112 with a neighboring FET device. This allows for a small cell size. One FET device is provided with a double gate (no gate around, but a gate at either side of the channel region 200, see in particular e.g. FIG. 22). If both gates at either side of a pinch-off FET are equally driven, the FET is either ON (conducting) or OFF (non-conducting). For half select devices (one gate is driven ON, and the gate on the other side is driven OFF), the gate voltages should be optimized such that they are not conductive.

Not only two adjacent pinch-off FET devices may share a common gate, a gate is moreover common for all pinch-off FET devices on a wordline WL.

The pinch-off FET devices function as a selector for the resistive memory cell provided electrically connected in series therewith.

The operation of a memory cell according to embodiments of the present invention, the memory cell being coupled in an array of memory cells, is as follows. A single cell (memory cell) can be addressed by controlling the voltage of a top electrode layer 122, forming a bitline 405, running over the cell to be addressed, and the two gate layers 112 of the pinch-off transistor forming the selection element 420 of the cell to be addressed. If a particular cell is to be addressed, e.g. for writing a value thereto or reading a value thereof, for example a cell located at logically organized row x and column y, in FIG. 5 and FIG. 6 indicated as cell_{x,y}, the bitline 405 of column y is put in a first state, e.g. a high state, and the gate 412 of the selector elements 420 of row x is put in a state for making the selector element active, e.g. a high state. With "the gate 412" is meant both gates 112 at either side of the channel 118 of the pinch-off FET functioning as selector element. As illustrated in FIG. 23, a pinch-off FET is only brought in an ON state when both gates 112 at either side of the channel are switched on. Half select devices are in the OFF state. If the gates 412 of row x are switched ON, all memory cells of row x can basically be addressed. However, only that memory cell of row x of which the bitline is put in the first state, e.g. high state will be effectively addressed. The resistive memory cell comprises a resistive active layer capable of having its resistivity changed in response to an electrical signal. This active layer is interposed between conductive top and bottom electrodes. The operation mechanism of a resistive memory cell is based on the fact that a dielectric, which is normally insulating, can be made to conduct through a filament or conduction path formed after application of a sufficiently high voltage. By bringing the bitline in the first state, e.g. high state, when the corresponding selector 420 is switched on, such filament or conduction path can be formed, and current can flow through the memory cell. The bottom electrode 101 or the conductive layer in the substrate 100 serves to drain the current flowing through the memory cell and guide it towards peripheral circuitry, e.g. writing or readout circuitry.

According to further embodiments, the present invention provides a memory circuit array comprising a vertical stack of at least a first and a second memory cell according to an embodiment of the present invention, wherein the metal layer 101 of the first and the second memory cell is shared. The memory circuit array may comprise a vertical stack of more than two memory cells. This way, not only the metal layer 101, but also the bit line 122 may be shared between adjacent memory cells in vertical direction in the stack. This is illustrated in FIG. 24. Such stacked memory circuit array allows to increase the density of memory cells.

## Claims

1. A memory cell comprising a first resistive switching element (142) connected in series with a selector (141), wherein the selector (141) is a first junction-less field-effect-transistor (FET).

2. A memory cell according to claim 1, wherein the first junction-less field-effect-transistor (141) is a vertical transistor.

3. A memory cell according to any of the previous claims, wherein the first junction-less field-effect transistor (141) comprises
- a stack (117) of layers substantially lying in a plane, the stack (117) at least comprising a conductive gate layer (112) in between a first (110) and a second dielectric layer (111);
- a region of transistor material (118) through the stack (117) of layers, the region of transistor material (118) comprising a bottom region (201), a top region (202) and a channel region (200) in between the bottom region (201) and the top region (202), the region of transistor material (118) comprising a semiconducting material with a doping concentration and doping polarity, wherein the region of transistor material (118) is arranged along a direction substantially perpendicular to the plane of the stack (117) of layers; and
- a gate dielectric layer (116) along at least the channel region (200), at least in between the channel region (200) and the conductive gate layer (112).

4. A memory cell according to any of the previous claims, wherein the first junction-less field-effect transistor (141) is made on a conductive layer (101) provided on a substrate (100) substantially parallel to the plane of the stack (117) of layers and in contact with the bottom region (201) of transistor material (118).

5. A memory cell according to claim 4, wherein the conductive layer (101) of the junction-less field-effect transistor (141) is patterned.

6. A memory cell according to any of the previous claims, wherein the first resistive switching element (142) comprises
- a top electrode (122);
- a resistive switching material (121) electrically connected to the top electrode (122); and
- a bottom electrode, the resistive switching element (142) being electrically connected between the top electrode (122) and the bottom electrode.

7. A memory cell according to claim 6, wherein the bottom electrode comprises metal deposited on top of the region of transistor material (118) of the first junction-less field-effect transistor (141).

8. A memory cell according to claim 6, wherein the bottom electrode comprises at least part of the top region of the first junction-less field-effect transistor (141).

9. A memory circuit (10) comprising a plurality of memory cells according to any of the previous claims, the memory circuit comprising a first memory cell comprising a first resistive switching element connected in series with a first junction-less field-effect-transistor (FET) and a second memory cell comprising a second resistive switching element connected in series with a second junction-less field-effect-transistor (FET), wherein the second junction-less field-effect-transistor (FET) is in parallel with the first junction-less field-effect-transistor (FET) and wherein the first junction-less field-effect-transistor (FET) and the second junction-less field-effect-transistor (FET) share a conductive gate layer (112).

10. A memory circuit (240) according to claim 9, comprising a vertical stack of at least a first and another memory cell according to any of claims 1 to 8.

11. A memory circuit (240) according to claim 10, wherein the another memory cell is physically top to bottom inverted with respect to the first memory cell.

12. A memory circuit (240) according to claim 11, the first and the other memory cell comprising a metal layer (101), wherein the metal layer (101) of the first and the other memory cell is shared.

13. Method of manufacturing a memory cell, the method comprising electrically connecting in series a resistive switching element (142) and a junction-less field-effect-transistor (141), the method comprising:
- Providing a stack (117) of layers on a substrate (100), the stack (117) of layers substantially lying in a plane (x,y), the stack (117) comprising a conductive gate layer (112) sandwiched in between a first (110) and a second dielectric layer (111);
- Providing a region of transistor material (118) through the stack (117) of layers, the region of transistor material (118) having a bottom region (201), a top region (202) and a channel region (200) in between the bottom region (201) and the top region (202), the region of transistor material (118) comprising a semiconducting material with a doping concentration and doping polarity, wherein the region of transistor material (118) is arranged along a direction substantially perpendicular to the plane of the stack (117) of layers;
- Providing a gate dielectric layer (116) along at least the channel region (200), at least in between the channel region (200) and the conductive gate layer (112);
- Providing a resistive switching material (121) on and in electrical contact with the top region (202) of transistor material (118);
- Providing a top electrode layer (122) on and in electrical contact with the resistive switching material (121).
- Providing an electrically conductive bottom electrode layer in between the top region (202) and the resistive switching material (121).

14. Method according to claim 13, furthermore comprising providing a metal layer (101) on the substrate.

15. Method according to claim 14, furthermore comprising, before providing the stack (117) of layers, patterning the metal layer (101).
